# EUROPEAN PATENT SPECIFICATION

(11) **EP 2 832 707 B1**
(45) Date of publication and mention of the grant of the patent: **28.12.2016**
(21) Application number: 13768966.7
(22) Date of filing: 27.03.2013
(51) Int. Cl.: C04B 35/462, H01L 41/08, H01L 41/187, H01L 41/39

(54) **PIEZOELECTRIC CERAMIC, PIEZOELECTRIC ELEMENT, AND METHOD FOR MANUFACTURING PIEZOELECTRIC CERAMIC**
PIEZOELEKTRISCHE KERAMIK, PIEZOELEKTRISCHES ELEMENT UND VERFAHREN ZUR HERSTELLUNG DER PIEZOELEKTRISCHEN KERAMIK
CÉRAMIQUE PIÉZOÉLECTRIQUE, ÉLÉMENT PIÉZOÉLECTRIQUE, ET PROCÉDÉ DE FABRICATION D'UNE CÉRAMIQUE PIÉZOÉLECTRIQUE

(30) Priority: 30.03.2012 JP 2012080783
(43) Date of publication of application: 04.02.2015
(73) Proprietor: Kyocera Corporation, Kyoto 612-8501 (JP)
(72) Inventor: KOMATSU, Tsuyoshi, Kyoto-shi Kyoto 612-8501 (JP)
(74) Representative: Viering, Jentschura & Partner mbB Patent- und Rechtsanwälte
(86) International application number: PCT/JP2013/059078
(87) International publication number: WO 2013/146915

(56) References cited:
- JP-A- 2002 167 276
- JP-A- 2008 184 336
- JP-A- 2011 213 538
- US-A1- 2003 178 918
- JAIN T A ET AL: "Effects of Bi4Ti3O12 addition on the microstructure and dielectric properties of modified BaTiO3 under a reducing atmosphere", JOURNAL OF THE EUROPEAN CERAMIC SOCIETY, ELSEVIER SCIENCE PUBLISHERS, BARKING, ESSEX, GB, vol. 29, no. 12, 26 March 2009 (2009-03-26), pages 2595-2601, XP026338251, ISSN: 0955-2219, DOI: 10.1016/J.JEURCERAMSOC.2009.02.015 [retrieved on 2009-03-26]

## Description

### Technical Field

The present invention relates to a piezoelectric ceramic and a piezoelectric element, particularly to a piezoelectric ceramic which is preferably used as a piezoelectric sensor, a piezoelectric element using the piezoelectric ceramic, and a method of manufacturing the piezoelectric ceramic.

### Background Art

As an example of products utilizing a piezoelectric ceramic, piezoelectric sensors, filters, piezoelectric resonators, ultrasonic oscillators, and ultrasonic motors can be given.

Piezoelectric sensors are used for shock sensors, acceleration sensors, in-vehicle knocking sensors, or the like. In recent years, pressure sensors have started to be practically used to directly detect the pressure within a cylinder in an engine of cars in order to optimize a timing of fuel injection from an injector, so that the fuel efficiency of the engine can be improved and the amount of exhaust gas (HC, NOₓ) can be reduced.

A pressure detecting device including a pressure sensor for detecting a change in pressure within an engine cylinder, for example, includes a pressure transmission pin and a piezoelectric sensor. The pressure transmission pin projects into the engine cylinder. The piezoelectric sensor is connected to the pressure transmission pin, receives the pressure in the cylinder through the pressure transmission pin, and outputs a charge (an output charge) corresponding to the pressure. A part of a head portion of the pressure transmission pin is in the cylinder in order to transmit the pressure within the cylinder. This head portion is exposed to high temperatures during combustion in the cylinder. In addition to a large change in pressure, high-temperature heat is also transmitted to the piezoelectric sensor connected to the pressure transmission pin; therefore, the temperature of the piezoelectric sensor reaches, for example, as high as 150 °C or higher.

Conventionally, a piezoelectric ceramic in a piezoelectric sensor contains, a PZT (lead zirconate titanate)-based material or a PT (lead titanate)-based material, which has a high piezoelectric property and a large piezoelectric constant d. In recent years, the demand for a piezoelectric ceramic using a lead-free material has been increasing.

In addition, since a PZT-based material or a PT-based material has a Curie temperature Tc of about 200 to 300 °C, the piezoelectric constant d at room temperature and the piezoelectric constant d under a high temperature when being used to detect the pressure within the engine cylinder significantly change; therefore, there has been a problem in that it is difficult to constantly output a charge corresponding to a pressure over a wide temperature range with high accuracy. In addition, a piezoelectric material containing a PZT-based material or a PT-based material does not have sufficiently high heat resistance. Thus, if such a material is used for a pressure sensor which directly detects the pressure in an engine cylinder, it may change with time under high-temperature exposure for a long time, resulting in a gradual change of the piezoelectric constant d over a long period of time.

As a piezoelectric ceramic alternative to the conventional piezoelectric ceramic, a piezoelectric ceramic containing, as a main component, a so-called bismuth layered compound which has a relatively high Curie temperature and does not contain lead has been suggested (for example, see Patent Literature 1). Since a piezoelectric ceramic containing a bismuth layered compound as a main component has a high Curie temperature of about 400 °C or higher, there is a small difference between the piezoelectric constant at room temperature and the piezoelectric constant at approximately 150 °C in the case, for example, where the piezoelectric ceramic is used for directly detecting the pressure in an engine cylinder and the temperature is increased. Such a piezoelectric ceramic containing a bismuth layered compound as a main component is able to output a charge corresponding to a pressure over a wide temperature range with high accuracy. Such a piezoelectric ceramic containing a bismuth layered compound as a main component is studied in order to be used, for example, for a pressure sensor which directly detects a pressure in an engine cylinder.

### Citation List

### Patent Literature

PTL 1: Japanese Unexamined Patent Application Publication No. 2002-167276

A further example of prior art may found in "Effects of Bi4Ti3O12 addition on the microstructure and dielectric properties of modified BaTiO3 under a reducing atmosphere", by Jain T A; Chen C C; Fung K Z; JOURNAL OF THE EUROPEAN CERAMIC SOCIETY VOL. 29, PG 2595-2601; ELSEVIER SCIENCE PUBLISHERS. In the paper the effects of Bi4Ti3O12 addition on the microstructure and dielectric properties of Mn-modified BaTiO3 were investigated to develop low temperature fired BaTiO3-based ceramics with stable temperature characteristics.

### Summary of Invention

### Technical Problem

However, as for the piezoelectric ceramic containing a bismuth layered compound as a main component which is described in Patent Literature 1, there is a problem in that hysteresis of a charge output from the piezoelectric ceramic (an output charge) when a load is applied is relatively large. That is, there is a big difference between an output charge generated when an applied load is increasing and an output charge generated when the applied load is decreasing. Accordingly, when such a piezoelectric ceramic is used for a piezoelectric element for a pressure sensor, for example, there is a problem in that the hysteresis causes an error in a load measured, and its pressure detection accuracy is degraded.

It is an object of the present invention to solve the above-described problems, and to provide a piezoelectric ceramic and a piezoelectric element which have good heat resistance and small hysteresis in the output charge output from the piezoelectric ceramic when a load is applied. Solution to Problem

In order to solve the above-described problems, the present invention provides a piezoelectric ceramic that includes a pair of main surfaces that are on opposing sides of a base body and parallel to each other; and a side surface continuous to an edge of each of the pair of main surfaces. The piezoelectric ceramic is used for measuring a pressure that is applied in a direction perpendicular to the pair of main surfaces. A main component of the piezoelectric ceramic is a layered compound that has a composition formula Bi₄Ti₃O₁₂·αMTiO₃ where M is at least one selected from Sr and Ba and α satisfies 0.1 ≤ α ≤ 1. The base body includes an outer region that includes the side surface and adjacent regions that are adjacent to the edges of the pair of main surfaces, and an inner region surrounded by the outer region. A full width half maximum W_{A} of a peak in a range where a diffraction angle (2θ) is 22.8° to 23.5° in an X-ray diffraction pattern using a Cu-Kα ray on the side surface of the outer region is smaller than a full width half maximum W_{B} of a peak in the range where a diffraction angle (2θ) is 22.8° to 23.5° in the X-ray diffraction pattern using the Cu-Kα ray on the main surface of the inner region.

In addition, the present invention provides a piezoelectric element including the piezoelectric ceramic and an electrode layer on each of the pair of main surfaces of the piezoelectric ceramic.

Further in addition, a method of manufacturing a piezoelectric ceramic including a step of obtaining a mixture powder by mixing a Bi₂O₃ powder, a TiO₂ powder, and at least one selected from a SrCO₃ powder and a BaCO₃ powder; a step of obtaining a molded body by molding the mixture powder, the molded body including a pair of molded main surfaces that are on opposing sides and parallel to each other and a molded side surface continuous to an edge of each of the pair of molded main surfaces; a firing step of obtaining a fired body by firing the molded body, the fired body including a pair of fired main surfaces that are formed by firing the pair of molded main surfaces and a fired side surface that is formed by firing the molded side surface, in which a main component is a layered compound that has a composition formula Bi₄Ti₃O₁₂·αMTiO₃ where M is at least one selected from Sr and Ba and α satisfies 0.1 ≤ α ≤ 1; and a polishing step of obtaining a piezoelectric ceramic by polishing the pair of fired main surfaces of the fired body, the piezoelectric ceramic including a pair of main surfaces that are on opposing sides of a base body and parallel to each other and a side surface continuous to an edge of each of the pair of main surfaces, and the base body including an outer region that includes the side surface and adjacent regions that are adjacent to the edges of the pair of main surfaces and an inner region surrounded by the outer region, in which a full width half maximum W_{A} of a peak in a range where a diffraction angle (2θ) is 22.8° to 23.5° in an X-ray diffraction pattern using a Cu-Kα ray on the side surface of the outer region is smaller than a full width half maximum W_{B} of a peak in the range where a diffraction angle (2θ) is 22.8° to 23.5° in the X-ray diffraction pattern using the Cu-Kα ray on the inner region.

### Advantageous Effects of Invention

The piezoelectric ceramic of the present invention contains, as a main component, a layered compound represented by a composition formula Bi₄Ti₃O₁₂·αMTiO₃ where M is at least one selected from Sr and Ba and α satisfies 0.1 ≤ α ≤ 1. In the piezoelectric ceramic, a full width half maximum W_{A} of a peak in a range where a diffraction angle (2θ) is 22.8° to 23.5° in X-ray diffraction using a Cu-Kα ray on a side surface of an outer region including the side surface and adjacent regions that are adjacent to edges of a pair of main surfaces is smaller than a full width half maximum W_{B} of a peak in the range where the diffraction angle (2θ) is 22.8° to 23.5° in X-ray diffraction using a Cu-Kα ray on a main surface of an inner region surrounded by the outer region. In other words, in the piezoelectric ceramic of the present invention, the outer region has a higher degree of regularity of the crystal structure and a higher Young's modulus and hardness than the inner region. Therefore, when a pressure is applied in the direction perpendicular to the main surfaces, deformation of a base body in a direction different from that direction is suppressed, whereby hysteresis of an output charge which is output when a load is applied is small. A piezoelectric ceramic element including the piezoelectric ceramic of the present invention also has small hysteresis of the output charge which is output when a load is applied. In a method of manufacturing the piezoelectric ceramic of the present invention, a fired main surface is polished after a firing step, whereby the piezoelectric ceramic can be manufactured at a relatively low cost.

### Brief Description of Drawings

[Fig. 1] Fig. 1 illustrates a piezoelectric ceramic 20 which is one embodiment of a piezoelectric ceramic of the present invention. Fig. 1(a) is a schematic perspective view of the piezoelectric ceramic 20 and Fig. 1(b) is a schematic cross-sectional view of the piezoelectric ceramic 20.
[Fig. 2] Fig. 2 is a schematic perspective view illustrating a piezoelectric element 30, which is one embodiment of a piezoelectric element of the present invention.
[Fig. 3] Fig. 3 is a schematic configuration diagram of an example of a measurement device for measuring a piezoelectric property of a piezoelectric element.
[Fig. 4] Fig. 4 is an example of a graph illustrating a relation between an applied load and an output charge measured by the measurement device illustrated in Fig. 3 when a load is applied to a piezoelectric element.
[Fig. 5] Fig. 5 is a schematic cross-sectional view illustrating an example of a part of a process in a method of manufacturing a piezoelectric element of the present invention. Fig. 5(a) illustrates a molded body formed by a molding step, Fig. 5(b) illustrates a fired body formed by a firing step, and Fig. 5(c) illustrates a piezoelectric ceramic obtained after a polishing step.
[Fig. 6] Fig. 6 is a schematic perspective view illustrating another embodiment of a piezoelectric ceramic.
[Fig. 7] Fig. 7(a) illustrates an X-ray diffraction spectrum obtained by X-ray diffraction using radiation of a Cu-Kα ray on a side surface of an outer region, in an example of a piezoelectric ceramic of the present invention and Fig. 7(b) illustrates an X-ray diffraction spectrum obtained by X-ray diffraction using radiation of a Cu-Kα ray on a main surface of an inner region of the piezoelectric ceramic of Fig. 7(a).

### Description of Embodiments

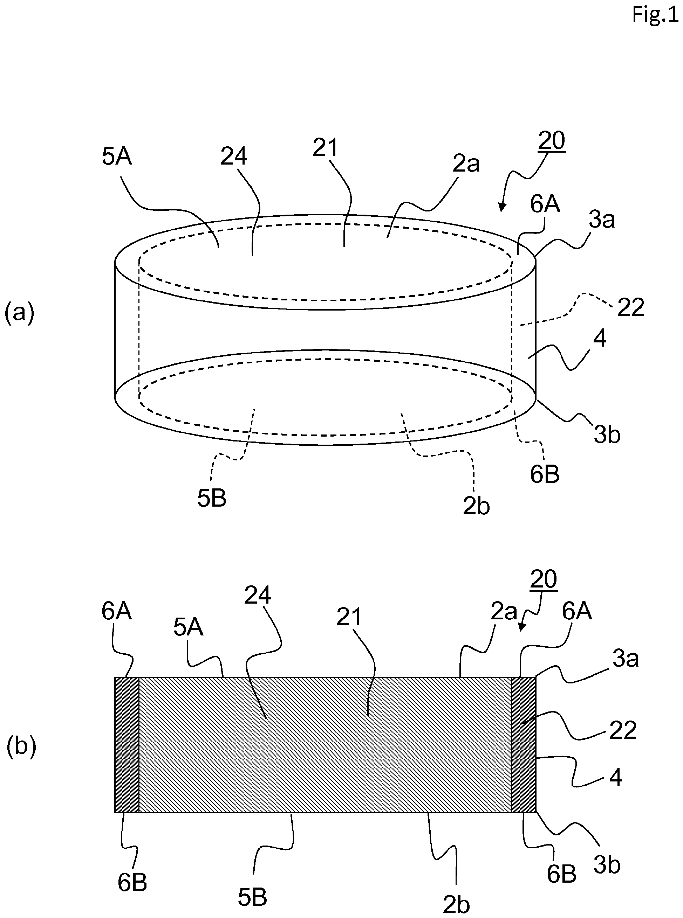

Fig. 1 illustrates the piezoelectric ceramic 20, which is one embodiment of a piezoelectric ceramic of the present invention. Fig. 1(a) is a schematic perspective view of the piezoelectric ceramic 20. Fig. 1(b) is a schematic cross-sectional view of the piezoelectric ceramic 20. The piezoelectric ceramic 20 includes a cylindrical base body 21, a pair of main surfaces 2a and 2b which are on opposing sides of the base body 21 and parallel to each other, and a side surface 4 continuous to an edge 3a of the main surface 2a and an edge 3b of the main surface 2b.

The piezoelectric ceramic 20 includes an outer region 22 and an inner region 24. The outer region 22 includes the side surface 4, an adjacent region 6A that is adjacent to the edge 3a of the main surface 2a, and an adjacent region 6B that is adjacent to the edge 3b of the main surface 2b. The inner region 24 is surrounded by the outer region 22. The main surface 2a includes a central region 5A which corresponds to the inner region 24 and is surrounded by the adjacent region 6A. The main surface 2b includes a central region 5B which corresponds to the inner region 24 and is surrounded by the adjacent region 6B. The main surfaces 2a and 2b of the base body 21 each have, for example, a circle shape with a diameter of about 12 mm. The thickness of the base body 21 in the direction perpendicular to the main surfaces 2a and 2b is, for example, about 5 mm.

Here, the term adjacent region 6A that is adjacent to the edge 3a of the main surface 2a refers to a region within a distance equal to 10% or less of the radius of the main surface 2a from the edge 3a. In the piezoelectric ceramic 20, the region within 1.2 mm from the edge 3a is referred to as the adjacent region 6A. Similarly, the adjacent region 6B that is adjacent to the edge 3b of the main surface 2b refers to a region within a distance equal to 10% or less of the radius of the main surface 2b from the edge 3b. In the piezoelectric ceramic 20, the region within 1.2 mm from the edge 3b is referred to as the adjacent region 6B.

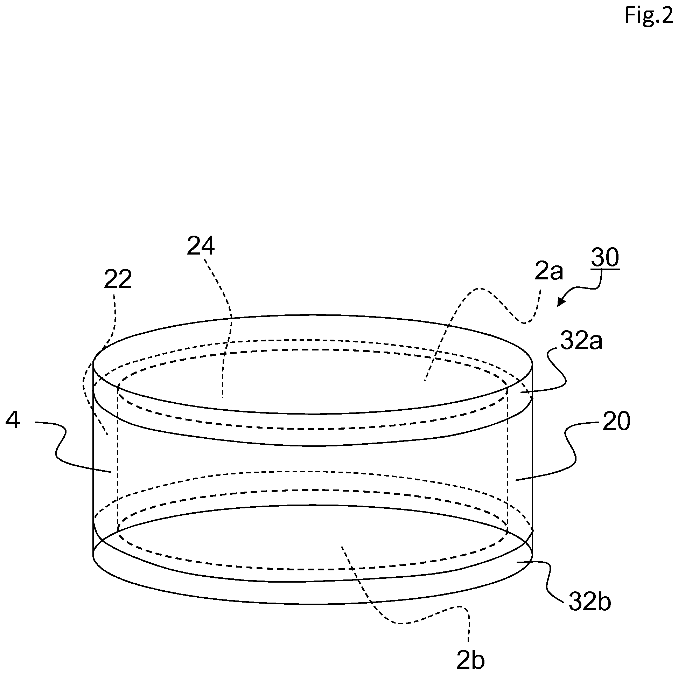

The piezoelectric ceramic 20 is used to measure a pressure applied to the pair of main surfaces 2a and 2b. Fig. 2 is a schematic perspective view of the piezoelectric element 30, which is one embodiment of a piezoelectric element of the present invention. The piezoelectric element 30 includes the piezoelectric ceramic 20 illustrated in Fig. 1, an electrode layer 32a on the main surface 2a of the piezoelectric ceramic 20, and an electrode layer 32b on the main surface 2b of the piezoelectric ceramic 20. The piezoelectric ceramic 20 has been applied with a voltage via the electrode layers 32a and 32b so as to be polarized in the direction perpendicular to the pair of main surfaces 2a and 2b. When a pressure is applied to the piezoelectric ceramic 20 in the direction perpendicular to the pair of main surfaces 2a and 2b, the piezoelectric element 30 outputs an output charge generated by the piezoelectric ceramic 20 to an electrode terminal or the like for measurement, which is not illustrated and is connected to the electrode layers 32a and 32b, via the electrode layers 32a and 32b. The piezoelectric ceramic of the present invention can be included in such a piezoelectric element as a component member.

The piezoelectric ceramic 20 contains a layered compound represented by a composition formula Bi₄Ti₃O₁₂·αMTiO₃ as a main component. In this composition formula, M is at least one selected from Sr and Ba and α satisfies 0.1 ≤ α ≤ 1. In other words, the piezoelectric ceramic 20 is a piezoelectric ceramic containing a so-called bismuth layered compound as a main component, and has a Curie temperature as high as about 400 °C or more.

In the piezoelectric ceramic 20, a full width half maximum W_{A} of a peak in a range where a diffraction angle (2θ) is 22.8° to 23.5° in X-ray diffraction using a Cu-Kα ray on the side surface 4 of the outer region 22 is smaller than a full width half maximum W_{B} of a peak in the range where the diffraction angle (2θ) is 22.8° to 23.5° in X-ray diffraction using a Cu-Kα ray on the main surface of the inner region 24 (the central region 5A).

The piezoelectric ceramic 20 contains a layered compound represented by a composition formula Bi₄Ti₃O₁₂·αMTiO₃ as a main component. This layered compound is a bismuth layered structure body having a morphotropic phase boundary (MPB) in which, in the general formula of a bismuth layered structure body (Bi₂O₂)²⁺ (αₘ₋₁αₘO₃ₘ₊₁)²⁻, types and amounts of constituent elements coordinated to the α site, and to the α site and the oxygen site are adjusted and a tetragonal crystal generated when m = 4 and an orthorhombic crystal generated when m = 3 are mixed. Thus, the layered compound has a particular piezoelectric property in the vicinity of the MPB, which is also known as a PZT property.

In X-ray diffraction analysis with radiation of a Cu-Kα ray on such a bismuth layered compound represented by a composition formula Bi₄Ti₃O₁₂·αMTiO₃ (M is at least one selected from Sr and Ba) using an X-ray diffraction device, an X-ray diffraction peak attributed to the (111) face of SrBi₈Ti₇O₂₇ and an X-ray diffraction peak attributed to the (110) face of BaBi₈Ti₇O₂₇ appear in a range where a diffraction angle (2θ) is 22.8° to 23.5°. Peaks in the range where the diffraction angle (2θ) is 22.8° to 23.5° correspond to an X-ray diffraction peak attributed to the (111) face of SrBi₈Ti₇O₂₇, an X-ray diffraction peak attributed to the (110) face of BaBi₈Ti₇O₂₇, or an X-ray diffraction peak attributed to the (111) face of SrBi₈Ti₇O₂₇ and an X-ray diffraction peak attributed to the (110) face of BaBi₈Ti₇O₂₇ overlapping with each other. Thus, in the range where the diffraction angle (2θ) is 22.8° to 23.5°, both of a peak corresponding to a crystal phase containing Sr and a peak corresponding to a crystal phase containing Ba appear. Thus, when a piezoelectric ceramic containing a bismuth layered compound represented by a composition formula Bi₄Ti₃O₁₂·αMTiO₃ (M is at least one selected from Sr and Ba) as a main crystal phase is irradiated with a Cu-Kα ray, a relatively high-intense peak appears in the range where the diffraction angle (2θ) is 22.8° to 23.5°, regardless of the content rates of Sr or Ba.

The term full width half maximum refers to the width across the diffraction pattern (2θ(°)) when it drops to half of its peak. The full width half maximum becomes high as the number of crystal defects in the measurement area becomes large, or the misalignment of atoms in the measurement area becomes large, that is, as the degree of regularity of the crystal structure in the measurement area becomes low. In other words, the full width half maximum of a peak in the range where the diffraction angle (2θ) is 22.8° to 23.5° corresponds to the degree of regularity of the crystal structure of at least one of SrBi₈Ti₇O₂₇ and BaBi₈Ti₇O₂₇ in the piezoelectric ceramic 20. The smaller the full width half maximum is, the higher degree of regularity the crystal structure of at least one of SrBi₈Ti₇O₂₇ and BaBi₈Ti₇O₂₇ has.

In the piezoelectric ceramic 20, the full width half maximum W_{A} of a peak in the range where the diffraction angle (2θ) is 22.8° to 23.5° in X-ray diffraction using radiation of a Cu-Kα ray on the side surface 4 is smaller than the full width half maximum W_{B} of a peak in the range where the diffraction angle (2θ) is 22.8° to 23.5° in X-ray diffraction using radiation of a Cu-Kα ray on the main surfaces of the inner region 24 (the central regions 5A and 5B). In other words, in the piezoelectric ceramic 20, the inner region 24 containing a bismuth layered compound having a crystal structure with a relatively low degree of regularity is surrounded by the outer region 22 containing a bismuth layered compound having a crystal structure with a relatively high degree of regularity. The outer region 22 has a crystal structure with a high degree of regularity compared to the inner region 24. The outer region 22 has a higher Young's modulus and hardness than the inner region 24.

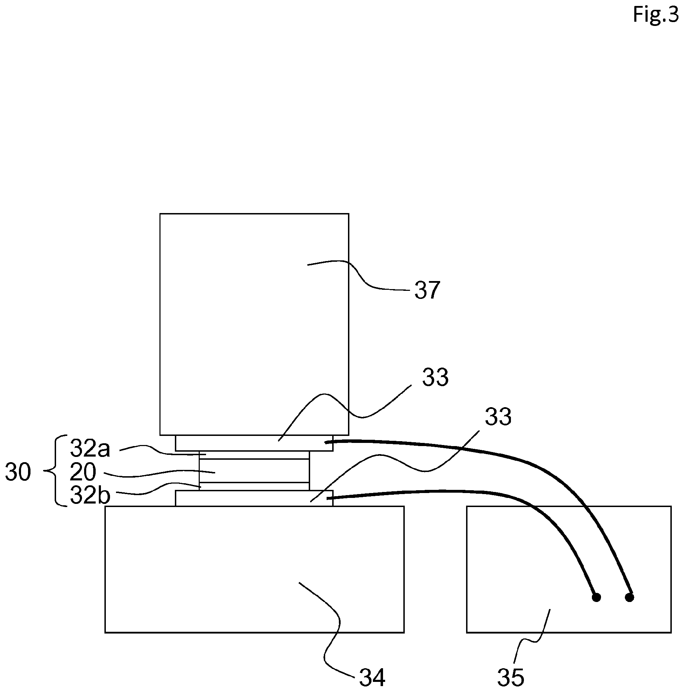

Here, an output charge and hysteresis thereof which are generated by a positive piezoelectric effect when a pressure is applied to the piezoelectric ceramic 20 are described. The output charge generated by a positive piezoelectric effect can be measured, for example, with a measurement device 31 in Fig. 3. The measurement device 31 in Fig. 3 includes a pedestal portion 34, a load application mechanism 37, two measurement electrodes 33, and a measuring instrument 35 including a so-called charge amplifier. The measurement electrodes 33 are plate-like members. The two measurement electrodes 33 are in contact with the electrode layers 32a and 32b of the piezoelectric element 30. Specifically, one of the measurement electrodes 33 is placed on the pedestal portion 34, the piezoelectric element 30 is placed thereon, and the other of the measurement electrodes 33 is placed thereon. The load application mechanism 37 applies a load to the piezoelectric element 30 via the measurement electrodes 33 in the downward direction in Fig. 3. The measuring instrument 35 is electrically connected to the two measurement electrodes 33. The measuring instrument 35 measures the level of a charge generated by the piezoelectric element 30 due to a load applied by the load application mechanism 37.

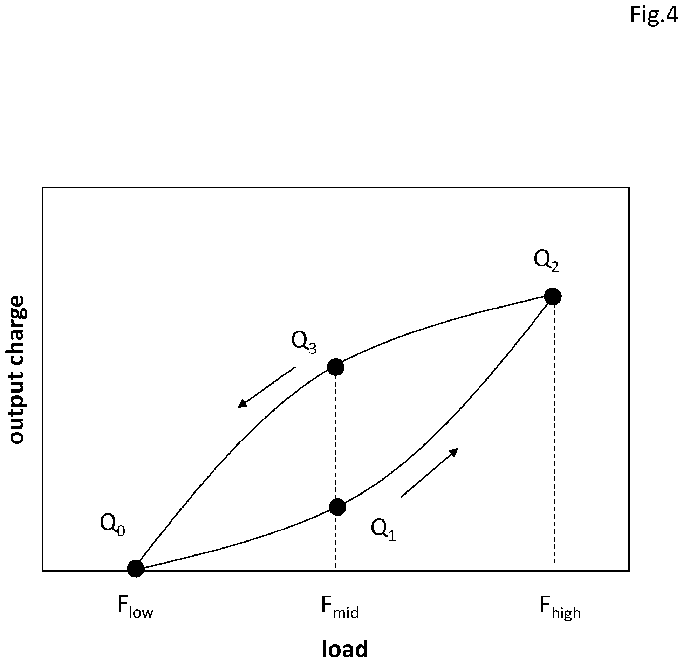

In the device in Fig. 3, a load F_{low} is applied as an initial load, then the load applied to the piezoelectric element 30 is increased to F_{high}, and then is reduced to F_{low}, and such an operation is repeated. During the operation, the output charge Q generated in the piezoelectric element 30 is measured by the measuring instrument 35. For example, the load application mechanism 37 applies a load, by using a triangular wave of 10 Hz in which F_{low} (= 250 N) is increased to F_{high} (= 300 N) and then is reduced to F_{low} (= 250 N) and such an operation is repeated. Fig. 4 is an example of a graph obtained by a measurement of a general piezoelectric element using the device in Fig. 3; the graph illustrates a relationship between a load applied to the piezoelectric element and an output charge. In Fig. 4, the arrows indicate whether a measurement value (the value of the output charge) is obtained when the load is being increased or when the load is being decreased. In Fig. 4, the output charge measured when the applied load is being increased is lower. Q₀ represents an output charge at the load F_{low}, Q₁ represents an output charge at the load F_{mid}(= (F_{low} + F_{high})/2) when the load is being increased, Q₂ represents an output charge at the load F_{high}, and Q₃ represents an output charge at the load F_{mid} when the load is being decreased. Q₁ and Q₃ do not coincide with each other, and the difference therebetween corresponds to hysteresis. Here, the value (Q₃-Q₁)/(Q₂-Q₀) is regarded as an index of hysteresis. In this description, the percentage (%) of this value is simply referred to as a hysteresis value.

As one of factors responsible for hysteresis, energy loss due to deformation of the piezoelectric ceramic in a direction different from the direction in which a load is applied is given. For example, when a pressure is applied to the pair of main surfaces 2a and 2b of the piezoelectric ceramic 20 in the direction perpendicular to the pair of main surfaces 2a and 2b of the piezoelectric ceramic 20, the piezoelectric ceramic 20 is deformed in a manner such that the piezoelectric ceramic 20 is compressed in the direction in which the load is applied and also deformed in a manner such that the piezoelectric ceramic 20 is expanded in the direction perpendicular to the direction in which the load is applied. Due to the deformation in the direction perpendicular to the direction in which the load is applied, energy of the applied pressure is lost without contribution to charge generation; therefore, a low output charge is measured when an applied load is being increased.

In the piezoelectric ceramic 20, the outer region 22 including the side surface 4 has higher crystallinity and a higher Young's modulus and hardness than the inner region 24. This outer region 22 suppresses the deformation of the inner region 24 in the direction perpendicular to the direction in which a load is applied. In other words, since the piezoelectric ceramic 20 includes the outer region 22 which has the side surface 4 and contains a bismuth layered compound having a crystal structure with a relatively high degree of regularity, the deformation of the inner region 24 in a direction different from the direction in which a load is applied is suppressed; thus, the energy loss due to the deformation in the different direction is suppressed. In particular, the energy loss due to excess deformation which occurs when a load is being increased can be suppressed, whereby the hysteresis value can be made small. When the volume of the outer region 22 and that of the inner region 24 surrounded by the outer region 22 are compared, the volume of the inner region 24 is larger and takes up a large portion of the volume of the base body 21. As for the amount of charge output from the whole piezoelectric ceramic 20 when a pressure is applied thereto, the charge generated in the inner region 24 is dominant. In the piezoelectric ceramic 20, since excess deformation of the inner region 24 surrounded by the outer region 22 is particularly suppressed and the inner region 24 deforms in the direction in which a load is applied with high accuracy, the piezoelectric ceramic 20 can output a charge corresponding to an applied pressure with high accuracy and a small hysteresis value.

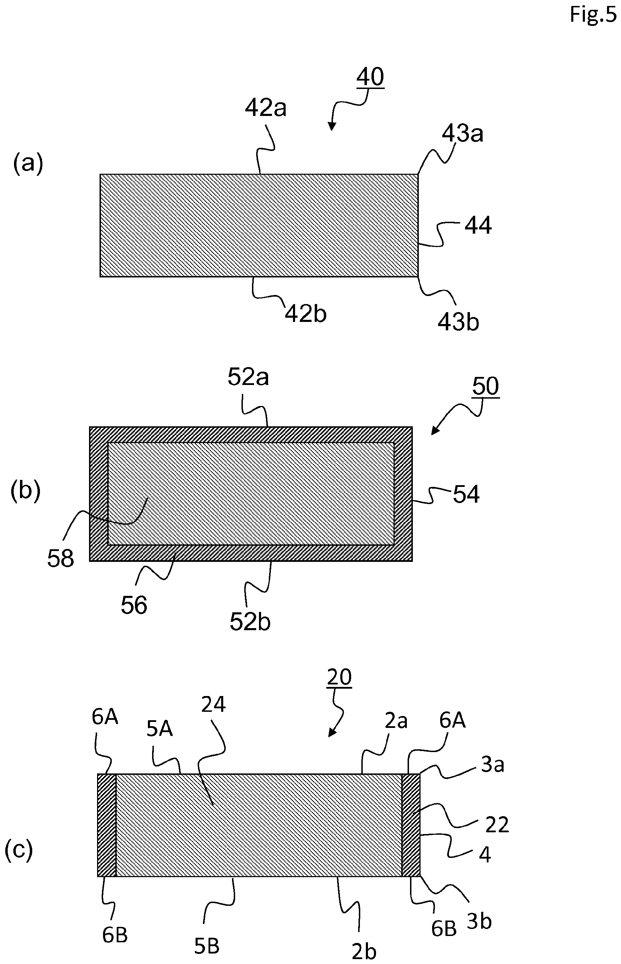

One embodiment of a method of manufacturing a piezoelectric ceramic of this application is described using a method of manufacturing the piezoelectric ceramic 20 as an example. The manufacturing method of this embodiment includes a step where a mixture powder is obtained by mixing a Bi₂O₃ powder, a TiO₂ powder, and at least one selected from a SrCO₃ powder and a BaCO₃ powder, a molding step where a molded body is obtained by molding the mixture powder, a firing step where the molded body is fired, and a polishing step where a part of the fired body is polished. Fig. 5 illustrates each of the steps after the molding step. Fig. 5(a) is a schematic cross-sectional view of a molded body 40 obtained by the molding step, Fig. 5(b) is a schematic cross-sectional view of a fired body 50 obtained by the firing step, and Fig. 5(c) is a schematic cross-sectional view of the piezoelectric ceramic 20 obtained after the polishing step.

First, a step for obtaining the mixture powder is described below. As starting materials, predetermined amounts of a Bi₂O₃ powder, a TiO₂ powder, and at least one selected from a SrCO₃ powder and a BaCO₃ powder with a high purity (for example, with a purity of 90 mass% or higher) are weighed. Then, the weighed powders are mixed, put into a ball mill together with zirconia balls and pure water, and mixed and pulverized, whereby a first slurry is manufactured. Then, the first slurry is spray dried with a spray drier, whereby a dried powder is manufactured. Then, the dried powder is calcined by being held in the air at 800 to 1100 °C for 1 to 10 hours, whereby a calcined powder is manufactured. The calcined powder is put into a ball mill together with zirconia balls and pure water and pulverized for 1 to 50 hours, whereby a slurry is manufactured. An organic binder such as polyethylene glycol is added to the slurry and mixed, whereby a second slurry is manufactured. Then, the second slurry is spray dried, whereby a mixture powder in which a Bi₂O₃ powder, a TiO₂ powder, and at least one selected from a SrCO₃ powder and a BaCO₃ powder are mixed is manufactured.

In the step for obtaining the mixture powder, although not all of the above processes are necessarily performed, for example, by spray drying the first slurry, a dried powder in which the materials (such as Bi₂O₃ and TiO₂) are preferably dispersed can be obtained or, by spray drying the second slurry, a mixture powder in which metal elements such as Bi and Ti are not so segregated and are preferably dispersed can be obtained. Segregation of materials in the mixture powder would lead to crystal defects or the like in the fired body after the firing step. Through above steps, crystal defects in the fired body after the firing step can be suppressed.

Then, this mixture powder is press molded with a press molding machine at a relatively low molding pressure of, for example, 50 to 100 MPa, whereby the molded body 40 illustrated in Fig. 5(a) is obtained. The molded body 40 includes a pair of molded main surfaces 42a and 42b which are on opposing sides and parallel to each other and a molded side surface 44 continuous to edges 43a and 43b of the pair of molded main surfaces 42a and 42b.

Then, the obtained molded body 40 is fired in the air at about 1100 to 1200 °C for 0.5 to 4 hours, whereby the fired body 50 illustrated in Fig. 5(b) is obtained. The fired body 50 includes fired main surfaces 52a and 52b, which are formed by firing the molded main surfaces 42a and 42b, and a fired side surface 54, which is formed by firing the molded side surface 44. The temperature of about 1100 to 1200 °C is relatively low as a firing temperature of a bismuth layered compound. When the molded body 40 is fired at about 1100 to 1200 °C for 0.5 to 4 hours, an inner portion of the molded body 40 is not sufficiently fired compared to a superficial portion of the molded body 40. In the fired body 50, a fired inner region 58 is surrounded by a fired superficial layer 56. The fired inner region 58 is not sufficiently fired and contains a bismuth layered compound with a relatively low degree of crystal structure regularity, while the fired superficial layer 56 is sufficiently fired, contains a bismuth layered compound with a high degree of crystal structure regularity, and includes the fired main surfaces 52a and 52b and the fired side surface 54.

Then, only the pair of fired main surfaces 52a and 52b of the fired body 50 are polished. In this polish, each of the fired main surfaces 52a and 52b is polished by about 1.5 mm in the depth direction. Although the amount of parts of the fired main surfaces 52a and 52b of the fired body 50 which are polished is not particularly limited, it is preferable that each of the fired main surfaces 52a and 52b is polished in the depth direction by the length of 10% of the radius of the fired main surface 52a. Through this polishing step, the piezoelectric ceramic 20 illustrated in Fig. 5(c) is obtained. The piezoelectric ceramic 20 includes the pair of main surfaces 2a and 2b parallel to each other; the side surface 4 continuous to the edge 3a of the main surface 2a and the edge 3b of the main surface 2b; the outer region 22 including the side surface 4, the adjacent region 6A, and the adjacent region 6B; and the inner region 24 surrounded by the outer region 22. In the piezoelectric ceramic 20, the full width half maximum W_{A} of a peak in the range where the diffraction angle (2θ) is 22.8° to 23.5° in X-ray diffraction using a Cu-Kα ray on the side surface 4 of the outer region 22 is smaller than the full width half maximum W_{B} of a peak in the range where the diffraction angle (2θ) is 22.8° to 23.5° in X-ray diffraction using a Cu-Kα ray on the main surface of the inner region 24.

The outer region 22 of the piezoelectric ceramic 20 corresponds to the fired superficial layer 56, which is sufficiently fired and has a relatively high degree of crystal structure regularity in the fired body 50. The outer region 22 has a relatively high degree of crystal structure regularity and high Young's modulus and hardness. The inner region 24 of the piezoelectric ceramic 20 corresponds to the fired inner region 58, which is not sufficiently fired and has a relatively low degree of crystal structure regularity in the fired body 50. In a method of manufacturing a piezoelectric ceramic of the present invention, a piezoelectric ceramic of the present invention can be manufactured for a relatively short time and at a low cost.

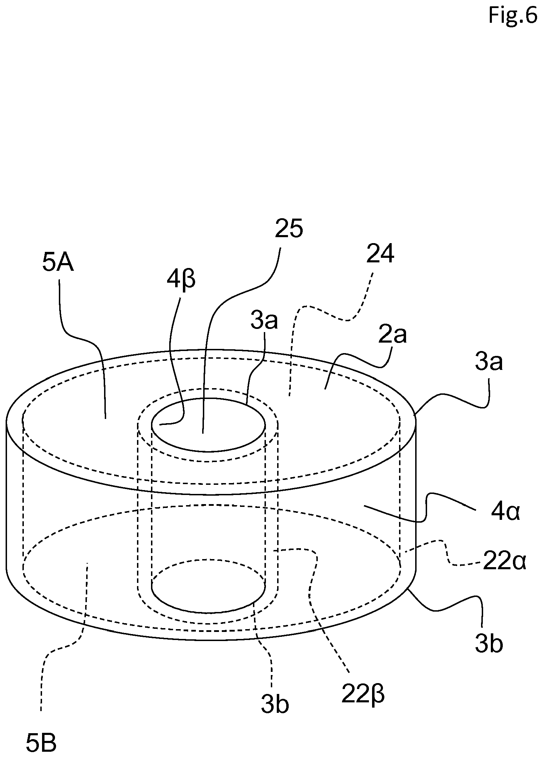

A shape of a piezoelectric ceramic and a piezoelectric ceramic element of the present invention is not limited to the above embodiment. The shape of the main surface of the piezoelectric ceramic may be, for example, a polygonal shape such as a triangle, square, or hexagon. Fig. 6 illustrates a piezoelectric ceramic of another embodiment. In the embodiment illustrated in Fig. 6, structures similar to those illustrated in Fig. 1 are indicated by the same reference numerals as those in Fig. 1. In the embodiment illustrated in Fig. 6, a through hole 25 having an opening in the main surface 2a and the main surface 2b is provided. As for the side surface connecting the edge 3a of the main surface 2a and the edge 3b of the main surface 2b, an outer side surface 4α and an inner side surface 4β, which is an inner peripheral surface of the through hole, are provided. As for the outer region, a first outer region 22α having the outer side surface 4α and a second outer region 22β having the inner side surface 4β are provided. In the embodiment illustrated in Fig. 6, each of a full width half maximum W_{Aα} of a peak in the range where the diffraction angle (2θ) is 22.8° to 23.5° in X-ray diffraction using radiation of a Cu-Kα ray on the outer side surface 4α and a full width half maximum W_{Aβ} of a peak in the range where the diffraction angle (2θ) is 22.8° to 23.5° in X-ray diffraction using radiation of a Cu-Kα ray on the inner side surface 4β is smaller than a full width half maximum W_{B} of a peak in the range where the diffraction angle (2θ) is 22.8° to 23.5° in X-ray diffraction using radiation of a Cu-Kα ray on the main surfaces of the inner region 24 between the first outer region 22α and the second outer region 22β (the central regions 5A and 5B). In the embodiment illustrated in Fig. 6, the inner region 24 is surrounded by the first outer region 22α and the second outer region 22β with a relatively high degree of crystal structure regularity, whereby the hysteresis value of the output charge when a pressure is applied can be made small.

Note that as in the case of the piezoelectric element 30 illustrated in Fig. 2, when the electrode layers 32a and 32b are attached to the main surfaces 2a and 2b, the surfaces of the piezoelectric ceramic 20 which are exposed by polishing and removing the electrode layers 32a and 32b can be regarded as the main surfaces 2a and 2b. As in the case of another embodiment, as for the main surfaces 2a and 2b which are exposed by polishing, the full width half maximum W_{B} of a peak in the range where the diffraction angle (2θ) is 22.8° to 23.5° in X-ray diffraction using radiation of a Cu-Kα ray on the main surfaces of the inner region 24 (the central regions 5A and 5B) is larger than the full width half maximum W_{A} of a peak in the range where the diffraction angle (2θ) is 22.8° to 23.5° in X-ray diffraction using radiation of a Cu-Kα ray on the side surface 4.

### EXAMPLES

As starting materials, a Bi₂O₃ powder, a TiO₂ powder, a SrCO₃ powder, and a BaCO₃ powder each having a high purity were weighed in a manner such that a composition formula by the molar ratio when those powders were brought together was Bi₄Ti₃O₁₂·αMTiO₃ where M is at least one selected from Sr and Ba and α is 0.5. Note that the SrCO₃ powder and the BaCO₃ powder are decomposed in calcination described later and CO₂ is gasified, whereby those powders become SrO and BaO, respectively. Specifically, those powders were weighed such that the molar ratio of those powders satisfied a Bi₂O₃ powder: a TiO₂ powder: a SrCO₃ powder = 4: 7: 1. Those weighed powders were mixed, put into a ball mill together with zirconia balls and pure water, and mixed and pulverized, whereby a first slurry was formed. The first slurry was spray dried with a spray drier, whereby a dried powder was formed. The dried powder was calcined by being held in the air at 900 °C for 3 hours, whereby a calcined powder was formed. The calcined powder was put into a ball mill together with zirconia balls and pure water and pulverized for 20 hours, whereby a slurry was formed. An organic binder of polyethylene glycol was added to the slurry and mixed, whereby a second slurry was formed. The second slurry was spray dried, whereby a powder for molding was formed. The powder for molding was molded by a press molding machine using a die with a pressure of 90 MPa into a cylinder with an outer diameter of 12 mm and a thickness of 5 mm, whereby a molded body was formed. Note that a plurality of molded bodies having the same composition were formed.

The molded body was fired in the air at 1100 to 1200 °C for 3 hours, whereby the fired body was formed. The fired body had a relative density of 90 to 94% with respect to the theoretical density of the composition formula. Then, a pair of fired main surfaces of the fired body were polished. The depth of parts to be polished in each of the fired main surfaces was set to be 1.5 mm. Thus, a piezoelectric ceramic which had a circular main surface with a diameter of about 12 mm, a thickness in the direction perpendicular to the main surfaces of 5 mm, and the structure illustrated in Fig. 1 was obtained.

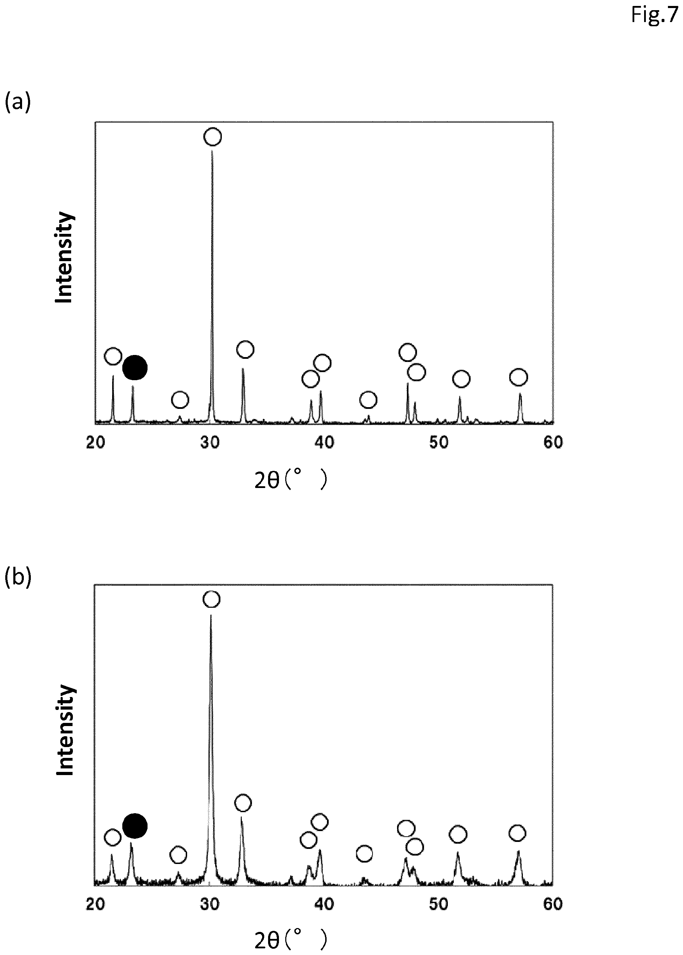

Fig. 7(a) illustrates an X-ray diffraction intensity spectrum which was obtained by X-ray diffraction using radiation of a Cu-Kα ray on the side surface of the outer region of the piezoelectric ceramic which was an example of a piezoelectric ceramic of the present invention obtained through the above-described process. Empyrean PW 6003/00 manufactured by Spectris Co., Ltd. was used as an X-ray diffraction device, and the measurement was performed under conditions of an X-ray output of 45 kV and 40 mA. Fig. 7(b) illustrates an X-ray diffraction intensity spectrum which was obtained by X-ray diffraction using radiation of a Cu-Kα ray on the main surface of the inner region of the piezoelectric ceramic which was the same as the piezoelectric ceramic of Fig. 7(a). In Figs. 7(a) and (b), black circular dots signify peaks in a range where a diffraction angle (2θ) is 22.8° to 23.5°. In the X-ray diffraction spectrum in Fig. 7(a), a full width half maximum W_{A} of a peak in the range where the diffraction angle (2θ) is 22.8° to 23.5° was 0.20°, whereas in the X-ray diffraction spectrum in Fig. 7(b), a full width half maximum W_{B} of the peak in the range where the diffraction angle (2θ) is 22.8° to 23.5° was 0.10°.

Then, an Ag electrode was baked on the two main surfaces of the piezoelectric ceramic, whereby electrode layers were formed. Then, polarization was performed by applying a DC voltage of about 5 kV/mm in the thickness direction under conditions of 200 °C, whereby a piezoelectric element having the structure illustrated in Fig. 2 was obtained. When a load expressed by a triangular wave of 10 Hz in which F_{low} = 250 N and F_{high} = 300 N was applied to this piezoelectric element using the device illustrated in Fig. 3, hysteresis was as small as 0.11% or less. For a reference example, a piezoelectric element was formed in the same manner as the above-described example except that the firing temperature in the firing step was a sufficiently high temperature of 1300 °C or higher and the polishing step was not performed, and the hysteresis was similarly measured. The hysteresis value thereof was as large as 1% or more.

The piezoelectric ceramic, the piezoelectric element, and the method of manufacturing the piezoelectric ceramic of the present invention are not limited to those in the above-descried Embodiments or Examples and various modifications and alterations are possible without departing from the scope of the present invention.

### Reference Signs List

- 5A and 5B: central region
- 6A and 6B: adjacent region
- 20: piezoelectric ceramic
- 21 base: body
- 2a and 2b: main surface
- 3a and 3b: edge
- 4 side: surface
- 22: outer region
- 24: inner region
- 30: piezoelectric element
- 32a: electrode layer
- 32b: electrode layer
- 40: molded body
- 42a and 42b: molded main surface
- 43a and 43b: edge
- 44: molded side surface
- 50: fired body
- 52a and 52b: fired main surface
- 56: fired superficial layer
- 58: fired inner region

## Claims

1. A piezoelectric ceramic comprising:
a pair of main surfaces that are on opposing sides of a base body and parallel to each other; and
a side surface continuous to an edge of each of the pair of main surfaces,
wherein the piezoelectric ceramic is used for measuring a pressure that is applied in a direction perpendicular to the pair of main surfaces,
wherein a main component is a layered compound that has a composition formula Bi₄Ti₃O₁₂·αMTiO₃ where M is at least one selected from Sr and Ba and α satisfies 0.1 ≤ α ≤ 1,
wherein the base body includes an outer region that includes the side surface and adjacent regions that are adjacent to the edges of the pair of main surfaces, and an inner region surrounded by the outer region, and
wherein a full width half maximum W_{A} of a peak in a range where a diffraction angle (2θ) is 22.8° to 23.5° in an X-ray diffraction pattern using a Cu-Kα ray on the side surface of the outer region is smaller than a full width half maximum W_{B} of a peak in the range where a diffraction angle (2θ) is 22.8° to 23.5° in the X-ray diffraction pattern using the Cu-Kα ray on the main surface of the inner region.

2. A piezoelectric element comprising:
the piezoelectric ceramic according to Claim 1; and
an electrode layer on each of the pair of main surfaces of the piezoelectric ceramic.

3. A method of manufacturing a piezoelectric ceramic comprising:
a step of obtaining a mixture powder by mixing a Bi₂O₃ powder, a TiO₂ powder, and at least one selected from a SrCO₃ powder and a BaCO₃ powder;
a step of obtaining a molded body by molding the mixture powder, the molded body including a pair of molded main surfaces that are on opposing sides and parallel to each other and a molded side surface continuous to an edge of each of the pair of molded main surfaces;
a firing step of obtaining a fired body by firing the molded body, the fired body including a pair of fired main surfaces that are formed by firing the pair of molded main surfaces and a fired side surface that is formed by firing the molded side surface, in which a main component is a layered compound that has a composition formula Bi₄Ti₃O₁₂·αMTiO₃ where M is at least one selected from Sr and Ba and α satisfies 0.1 ≤ α ≤ 1; and
a polishing step of obtaining a piezoelectric ceramic by polishing the pair of fired main surfaces of the fired body, the piezoelectric ceramic including a pair of main surfaces that are on opposing sides of a base body and parallel to each other and a side surface continuous to an edge of each of the pair of main surfaces, and the base body including an outer region that includes the side surface and adjacent regions that are adjacent to the edges of the pair of main surfaces and an inner region surrounded by the outer region, in which a full width half maximum W_{A} of a peak in a range where a diffraction angle (2θ) is 22.8° to 23.5° in an X-ray diffraction pattern using a Cu-Kα ray on the side surface of the outer region is smaller than a full width half maximum W_{B} of a peak in the range where a diffraction angle (2θ) is 22.8° to 23.5° in the X-ray diffraction pattern using the Cu-Kα ray on the inner region.

## Patentansprüche

1. Eine piezoelektrische Keramik, aufweisend:
ein Paar Hauptflächen, die sich auf einander entgegengesetzten Seiten eines Basiskörpers befinden und parallel zueinander sind, und
eine Seitenfläche, die zu einem Rand von jeder von dem Paar von Hauptflächen durchgeht,
wobei die piezoelektrische Keramik zum Messen eines Drucks verwendet wird, der in einer Richtung senkrecht zu dem Paar von Hauptflächen aufgebracht wird,
wobei ein Hauptbestandteil ein Schichtverbund ist, der eine Zusammensetzungsformel Bi₄Ti₃O₁₂ ·αMTiO₃ hat, wobei M mindestens eines ist, das aus Sr und Ba ausgewählt ist, und α 0,1 ≤ α ≤ 1 erfüllt,
wobei der Basiskörper einen äußeren Bereich, der die Seitenfläche und benachbarte Bereiche enthält, die benachbart zu den Rändern des Paares von Hauptflächen sind, und einen inneren Bereich, der von dem äußeren Bereich umgeben ist, enthält,
wobei eine Halbwertsbreite W_{A} eines Höchstwertes in einem Bereich, in dem ein Beugungswinkel (2θ) in einem Röntgen-Beugungsmuster unter Verwendung eines Cu-Kα-Strahls 22,8° bis 23,5° beträgt, auf der Seitenfläche des äußeren Bereichs kleiner als eine Halbwertsbreite W_{B} eines Höchstwertes auf der Hauptfläche des inneren Bereichs in dem Bereich ist, in dem ein Beugungswinkel (2θ) in dem Röntgen-Beugungsmuster unter Verwendung des Cu-Kα-Strahls 22,8° bis 23,5° beträgt.

2. Ein piezoelektrisches Element, aufweisend:
die piezoelektrische Keramik gemäß Anspruch 1, und
eine Elektrodenschicht auf jeder von dem Paar von Hauptflächen der piezoelektrischen Keramik.

3. Ein Verfahren zum Herstellen einer piezoelektrischen Keramik, aufweisend:
einen Schritt zum Erhalten eines Mischpulvers durch Mischen eines Bi₂O₂-Pulvers, eines TiO₂-Pulvers und mindestens eines Pulvers, das aus einem SrCO₂-Pulver und einem BaCO₃-Pulver ausgewählt wird,
einen Schritt zum Erhalten eines Formkörpers durch Formen des Mischpulvers, wobei der Formkörper ein Paar geformter Hauptflächen, die sich auf entgegengesetzten Seiten befinden und parallel zueinander sind, und eine geformte Seitenfläche aufweist, die zu einem Rand von jeder von dem Paar von geformten Hauptflächen durchgeht,
einen Brennschritt zum Erhalten eines gebrannten Körpers durch Brennen des Formkörpers, wobei der gebrannte Körper ein Paar gebrannter Hauptflächen, die durch Brennen des Paares geformter Hauptflächen geformt sind, und eine gebrannte Seitenfläche aufweist, die durch Brennen der geformten Seitenfläche erhalten wird, wobei ein Hauptbestandteil ein Schichtverbund ist, der eine Zusammensetzungsformel Bi₄Ti₃O₁₂ ·αMTiO₃ hat, wobei M mindestens eines ist, das aus Sr und Ba ausgewählt wird, und α 0,1 ≤ α ≤ 1 erfüllt, und
einen Polierschritt zum Erhalten einer piezoelektrischen Keramik durch Polieren des Paares von gebrannten Hauptflächen des gebrannten Körpers, wobei die piezoelektrische Keramik ein Paar Hauptflächen, die sich auf entgegengesetzten Seiten eines Basiskörpers befinden und parallel zueinander sind, und eine Seitenfläche aufweist, die zu einem Rand von jeder von dem Paar von Hauptflächen durchgeht, und wobei der Basiskörper einen äußeren Bereich, der die Seitenfläche und benachbarte Bereiche enthält, die benachbart zu den Rändern des Paares von Hauptflächen sind, und einen inneren Bereich enthält, der von dem äußeren Bereich umgeben ist, wobei eine Halbwertsbreite W_{A} eines Höchstwertes in einem Bereich, in dem ein Beugungswinkel (2θ) in einem Röntgen-Beugungsmuster unter Verwendung eines Cu-Kα-Strahls 22,8° bis 23,5° beträgt, auf der Seitenfläche des äußeren Bereichs kleiner als eine Halbwertsbreite W_{B} eines Höchstwertes an den des inneren Bereich in dem Bereich ist, in dem ein Beugungswinkel (2θ) in dem Röntgen-Beugungsmuster unter Verwendung des Cu-Kα-Strahls 22,8° bis 23,5° beträgt.

## Revendications

1. Une céramique piézoélectrique, comportant :
une paire de surfaces principales qui sont sur des côtés opposés d'un corps de base et parallèles l'une à l'autre, et
une surface latérale continue jusqu'à un rebord de chacune de la paire de surfaces principales,
dans laquelle la céramique piézoélectrique est utilisée pour mesurer une pression appliquée dans une direction perpendiculaire à la paire de surfaces principales,
dans laquelle un composant principal est un composite de couches qui a une formule de composition de Bi₄Ti₃O₁₂ ·αMTiO₃, où M est au moins un choisi parmi le Sr et le Ba et α satisfait à 0,1 ≤ α ≤ 1,
dans laquelle le corps de base comprend une région extérieure qui comprend la surface latérale et des régions adjacentes qui sont adjacentes aux rebords de la paire de surface principales, et une région intérieure entourée par la région extérieure, et
dans laquelle une largeur complète à mi-hauteur W_{A} d'un maximum dans une gamme où un angle de diffraction (2θ) est de 22,8° à 23,5° dans un motif de diffraction des rayons X en utilisant un rayon Cu-Kα sur la surface latérale de la région extérieure est inférieure à une largeur complète à mi-hauteur W_{B} d'un maximum dans la gamme où un angle de diffraction (2θ) est de 22,8° à 23,5° dans le motif de diffraction des rayons X en utilisant le rayon Cu-Kα sur la surface principale de la région intérieure.

2. Un élément piézoélectrique, comportant :
la céramique piézoélectrique selon la revendication 1, et,
une couche d'électrode sur chacune de la paire de surfaces principales de la céramique piézoélectrique.

3. Un procédé de fabrication d'une céramique piézoélectrique, comportant :
une étape pour obtenir une poudre de mélange en mélangeant une poudre Bi₂O₂, une poudre TiO₂ et au moins une choisie parmi une poudre SrCO₂ et une poudre BaCO₃,
une étape pour obtenir un corps moulé en moulant la poudre de mélange, le corps moulu comprenant une paire de surfaces principales moulues qui sont sur des côtés opposés et parallèles l'une à l'autre et une surface latérale moulue continue jusqu'à un rebord de chacune de la paire de surfaces principales moulues,
une étape de cuisson pour obtenir un corps cuit par cuisson du corps moulu, le corps cuit comprenant une paire de surfaces principales cuites qui sont formées par cuisson de la paire de surfaces principales moulues et une surface latérale cuite qui est formée par cuisson de la surface latérale moulue, dans lesquelles un composant principal est un composite de couches qui a une formule de composition de Bi₄Ti₃O₁₂ ·αMTiO₃, où M est au moins un choisi parmi le Sr et le Ba et α satisfait à 0,1 ≤ α ≤ 1, et
une étape de polissage pour obtenir une céramique piézoélectrique en polissant la paire de surfaces principales cuites du corps cuit, la céramique piézoélectrique comprenant une paire de surfaces principales qui sont sur des côtés opposés du corps de base et parallèles l'une à l'autre et une surface latérale continue jusqu'à un rebord de chacune de la paire de surface principales, et le corps de base comprenant une région extérieure qui comprend la surface latérale et des régions adjacentes qui sont adjacentes aux rebords de la paire de surfaces principales et une région intérieure entourée par la région extérieure, dans laquelle une largeur complète à mi-hauteur W_{A} d'un maximum dans une gamme où un angle de diffraction (2θ) est de 22,8° à 23,5° dans un motif de diffraction des rayons X en utilisant un rayon Cu-Kα sur la surface latérale de la région extérieure est inférieure à une largeur complète à mi-hauteur W_{B} d'un maximum dans la gamme où un angle de diffraction (2θ) est de 22,8° à 23,5° dans le motif de diffraction des rayons X en utilisant le rayon Cu-Kα sur la région intérieure.
